Europäisches Patentamt

European Patent Office

Office européen des brevets

(11) Publication number : **0 484 180 A1**

## (12) EUROPEAN PATENT APPLICATION

(21) Application number : **91310135.8**

(22) Date of filing : **01.11.91**

(51) Int. Cl.⁵ : **H01L 23/31,** H01L 23/433, H01L 21/56

(30) Priority : **01.11.90 JP 293657/90
28.03.91 JP 64829/90**

(43) Date of publication of application :
**06.05.92 Bulletin 92/19**

(84) Designated Contracting States :
**DE FR GB**

(71) Applicant : **FUJITSU LIMITED
1015, Kamikodanaka Nakahara-ku
Kawasaki-shi Kanagawa 211 (JP)**
(71) Applicant : **FUJITSU VLSI LIMITED
1844-2, Kozoji-cho 2-chome
Kasugai-shi Aichi 487 (JP)**

(72) Inventor : **Tsuji, Kazuto
c/o Fujitsu Limited, 1015, Kamikodanaka
Kawasaki-shi, Kangawa 211 (JP)**
Inventor : **Yoneda, Yoshiyuki
c/o Fujitsu Limited, 1015, Kamikodanaka
Kawasaki-shi, Kangawa 211 (JP)**
Inventor : **Kachi, Takuya, c/o Fujitsu VLSI
Limited
1844 -2, Kozoji-cho 2-chome
Kasugai-shi, Aichi, 487 (JP)**

(74) Representative : **Fane, Christopher Robin King
et al
HASELTINE LAKE & CO. Hazlitt House 28
Southampton Buildings Chancery Lane
London, WC2A 1AT (GB)**

(54) **Packaged semiconductor device having an optimized heat dissipation.**

㊷ A packaged semiconductor device comprises a semiconductor chip (1), a heat dissipating block (10) having a first major surface (B) of a first surface area and establishing a contact with said semiconductor chip and a second major surface (A) of a second surface area substantially larger than the first surface area, a resin package body (5) having first and second, opposing major surfaces and accommodating therein the semiconductor chip such that the second major surface of the heat dissipating block is exposed at the second major surface of the package body, an interconnection lead (3) held by the package body and extending outward therefrom for external electrical connection ; and a bonding wire (4) extending inside the package body for connecting the interconnection lead to the semiconductor chip.

FIG. 2A

EP 0 484 180 A1

Jouve, 18, rue Saint-Denis, 75001 PARIS

BACKGROUND OF THE INVENTION

The present invention generally relates to semiconductor devices and more particularly to a packaged semiconductor device having a heat sink structure.

With the increase in the integration density and associated increase in the operational speed of integrated circuits, efficient heat dissipation is becoming a serious problem in designing the package of the semiconductor device. This problem is particularly acute in the resin sealed packages that generally have a high thermal resistance.

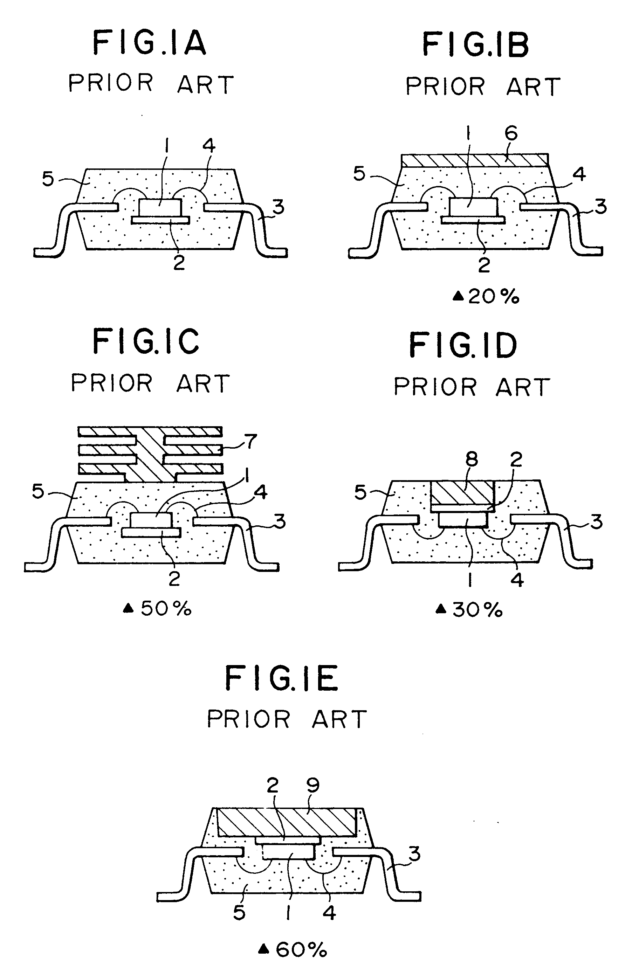

In order to overcome the problem of heat dissipation, the resin sealed packages generally use various heat sink structures some of which are shown in FIGS.1(A) - 1(E).

Referring to FIG.1(A), the package includes a semiconductor chip 1 mounded on a lead frame stage 2, and the chip 1 and the stage 2 are embedded in a plastic package body 5 together with a lead frame 3. It should be noted that the lead frame stage 2 is formed as a part of the lead frame 3 as usual. Bonding wires 4 connect the inner leads of the lead frame 3 to corresponding bonding pads provided on the chip 1. This package, however, has no heat sink structure and hence the problem of accumulation of heat in the package body when a semiconductor chip having an increased integration density is used for the chip 1. In the experiment conducted on the package having the QFP (quad-flat package) structure with the size of 28 X 28 X 3.35 mm and the number of pins of 208, it was shown that the device has the thermal resistance of 48 °C/W. The measurement was made under the no air-flow condition.

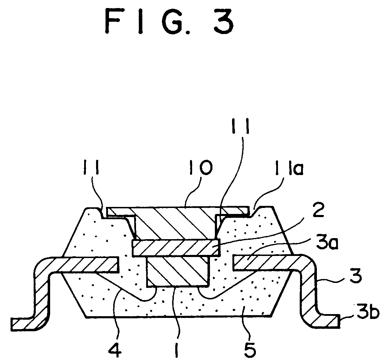

In the package structure of FIG.3(B), on the other hand, a heat sink plate 6 is provided on the entire top surface of the resin package body 5. As a result of use of the heat sink plate 6, one can reduce the thermal resistance by about 20 % with respect to the structure of FIG.1(A). For example, the package having the QFP structure of the same size and construction as the device of FIG.1(A) except for the heat sink 6, was shown to have the thermal resistance is 37 °C/W. This amount of decrease of the thermal resistance is generally not satisfactory for using the package for accommodating the recent integrated circuits having a very large integration density.

FIG.1(C) shows another example of the package, wherein a heat sink structure having a number of heat radiating fins 7 is provided on the top surface of the package body 5. In this type of package, one can achieve the reduction of the thermal resistance by about 50 %, and the package is suitable for the present-day large-scale integrated circuits. For example, the package having the QFP structure of the same size and construction as the device of FIG.1(A) except for the heat sink 7, was shown to have the thermal resistance of 25 °C/W. The above data of thermal resistance was obtained by the heat sink 7 that has six fins each having a diameter of 40 mm. On the other hand, because of the bulky heat sink structure, the package tends to cause problem in the mounting on the apparatuses or circuits in which the integrated circuit is to be used. Particularly, there sometimes arises a case wherein the mounting of the semiconductor device is impossible because of the limited space available for the heat sink structure.

FIG.1(D) shows another example of the package, wherein a heat sink block 8 is attached to the lead frame stage 2 at a side opposite from the side on which the semiconductor chip 1 is mounted. Although this structure is preferable from the view point of reducing the outer dimension of the package, the reduction in the thermal resistance that is achieved by the block 8 is limited to about 30 % that is not satisfactory for the thermal resistance of the package for use in the large-scale integrated circuits. For example, the package having the QFP structure of the same size and construction as the device of FIG.1(D) except for the heat sink 8 was shown to have the thermal resistance of 33 °C/W.

FIG.1(E) shows still another example of the package, wherein a heat sink block 9 is used instead of the block 8 to extend for a majority part of the top surface of the package body 5. Similar to the example of FIG.1(D), the block 9 is embedded in the resin package body 5. According to the structure of FIG.1(E), one can achieve the reduction of thermal resistance of as much as 60 % as compared to the reference package structure of FIG.1(A). More specifically, the package having the same size and construction as the package of FIG.1(A) except for the heat sink 9 was shown to have the thermal resistance of 19 °C/W. Thus, the package of FIG.1(E) is suitable for the large-scale to very-large-scale integrated circuits.

On the other hand, it was found that the package of FIG.1(E) shows a problem when mounting the semiconductor device on a substrate such as a printed circuit board. More particularly, when the semiconductor device is mounted on a printed circuit board by the localized heating process that employs localized heating caused by a laser beam or solder iron for effecting the reflow of solder, the heat applied to the leads 3 dissipates quickly to the heat dissipating block 9. Thereby, the desired reflow of solder for bonding the leads 3 to corresponding circuit patterns on the printed circuit board does not occur, and the reliable mounting of the semiconductor device on the printed circuit board is not realized. Obviously, this problem of poor bonding is caused by the excessive efficiency of heat dissipation caused by the heat sink block 9.

The structure of FIG.1(E) has another problem of separation between the heat sink block 9 and the resin package body 5 upon application of cyclic temperature variation. Such a temperature cycle tends to induce a crack between the block 9 and the resin package body 5, and moisture released by the resin tends to concentrate and increase the crack upon prolonged use. Thereby, the heat sink block may come off from the package body 5. Alternatively, such a crack may propagate inside the package body 5 and cause various problems such as the disconnection of the bonding wire 4, coming off of the leads 3, and the like. Thereby, the reliability and lifetime of the semiconductor device is inevitably deteriorated.

## SUMMARY OF THE INVENTION

Accordingly, it is a general object of the present invention to provide a novel and useful packaged semiconductor device having an optimized heat dissipation.

Another and more specific object is to provide a packaged semiconductor device having a heat sink structure that provides a sufficiently large heat dissipation for guaranteeing the operation of a large-scale integrated circuit, while simultaneously retarding the dissipation of the heat that is applied to a lead of the semiconductor device when mounting the semiconductor device on a substrate.

Another object of the present invention is to provide a packaged semiconductor device comprising a a semiconductor chip having a first major surface and a second, opposing major surface; a heat dissipating block having a major first surface and a second, opposing major surface, said first major surface of the heat dissipating block having a first surface area and establishing a contact with one of said first and second major surfaces of the semiconductor chip, said second major surface of the heat dissipating block having a second surface area substantially larger than said first surface area; a package body having first and second, opposing major surfaces and accommodating therein said semiconductor chip between said first major surface and said second major surface of the package body, said second major surface of the package body being substantially coincident with said second major surface of the heat dissipating block, said second major surface of the package body having a third surface area wherein said second surface area is equal to or larger than 90 percent of the third surface area; interconnection leads held by the package body and extending outward therefrom for external electrical connection; and bonding wires extending inside the package body for connecting the interconnection leads to the semiconductor chip. According to the present invention, the second surface of the heat dissipating block that is exposed to the exterior of the package body is separated from the interconnection leads. Thereby, the problem of dissipation of the heat applied to the interconnection leads at the time of mounting the semiconductor device on a substrate via the heat dissipating block, is retarded, and a heating sufficient to cause the reflow of solder is obtained at the outer tip end of the leads. On the other hand, the heat generated by the semiconductor chip upon the operation is efficiently dissipated from the first surface to the second surface of the heat dissipating block due to the large surface area of the second surface of the heat dissipating block.

Another object of the present invention is to provide a package structure for eliminating formation of cracks between a heat sink block and a resign package in which said heat sink block is embedded.

Another object of the present invention is to provide a package structure comprising a resin package body, a semiconductor chip held in the resin package body, and a heat sink block embedded in the resin package body to have an exposed surface that is coincident with a major surface of the package body, wherein there is provided a gap separating the heat sink block and the package body to surround the block laterally. According to the present invention, water or moisture released from the resin package body and causing cracks between the heat sink block and the resin package body, escapes efficiently to the outside of the package body through the gap, without causing the formation of cracks.

Another object of the present invention is to provide a method for manufacturing a packaged semiconductor body including a step of holding a semiconductor chip in a cavity and a step of pouring a resin into said cavity to form a resin package body in which said semiconductor chip is embedded, wherein said step of holding the semiconductor chip includes a step of applying a suction through a vent provided in the mold such that the semiconductor cip is held firmly against the mold during the pouring of the molten resin. According to the present invention, one can eliminate the problem of the semiconductor chip displacing in the cavity upon pouring of the molten resin. Thereby, one can manufacture the semiconductor device with reliability and improved yield.

Other objects and further features of the present invention will become apparent from the following detailed description when read in conjunction with the attached drawings.

## BRIEF DESCRIPTION OF THE DRAWINGS

FIGS.1(A) - 1(E) are diagrams showing various conventional semiconductor devices and heat sink structures;
FIGS.2(A) - 2(C) are diagrams showing the semiconductor device according to a first embodiment of the present invention;
FIG.3 is a diagram showing the semiconductor device according to a second embodiment of the present invention;

FIGS.4(A) - 4(E) are diagrams showing the process for manufacturing the semiconductor device of FIG.3;

FIG.5 is a diagram showing the semiconductor device according to a third embodiment of the present invention;

FIG.6 is a diagram showing a process used for manufacturing the semiconductor device of FIG.5;

FIG.7 is a diagram showing the semiconductor device according to a fourth embodiment of the present invention;

FIGS.8(A) and 8(B) are diagrams showing the process for manufacturing the semiconductor device of FIG.7;

FIG.9 is a diagram showing the semiconductor device according to a fifth embodiment of the present invention;

FIGS.10(A) and 10(B) are diagrams showing the process for manufacturing the semiconductor device of FIG.10; and

FIG.11 is a diagram showing the semiconductor device according to a sixth embodiment of the present invention.

DETAILED DESCRIPTION

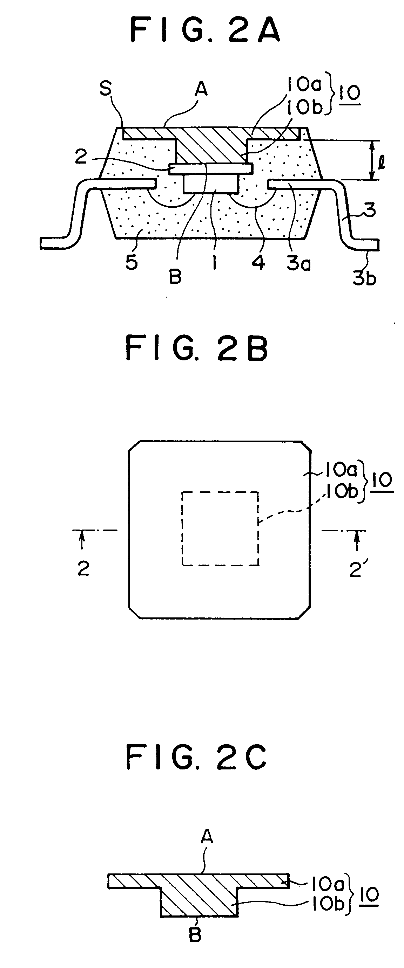

FIGS.2(A) - 2(C) are diagrams showing the semiconductor device according to a first embodiment of the present invention, wherein FIG.2(A) shows the elevational cross section of the semiconductor device while FIGS.2(B) and 2(C) show the top view and cross sectional view of the heat sink used in the semiconductor device of FIG.2(A). In these drawings, the parts that are substantially identical with the parts described previously are designated by the same corresponding reference numerals and the description thereof will be omitted.

Referring to FIG.2(A), the semiconductor device has a similar construction as the conventional device of FIG.1(E) except that the heat sink 9 is replaced with a heat sink 10 that is embedded in the package body 5. The heat sink 10 includes a heat radiation part 10a defined by a top surface A for radiating the heat and a heat conduction part 10b defined by a bottom surface B for conducting the heat from the semiconductor chip 1 to the heat radiation part 10a.

It should be noted that the surface A of the heat radiation part 10a is made substantially larger than the surface B of the heat conduction part 10b. See the plan view of FIG.2(B) and the cross sectional view of FIG.2(C), wherein FIG.2(C) shows the cross section taken along a line 2-2' of FIG.2(B).

As shown in FIG.2(A), the heat sink 10 is attached to the semiconductor device such that the surface B establishes a contact with the semiconductor chip 1 via the lead frame stage 2. Thereby, the radiation part 10a is separated from the lead 3 by a distance $\ell$, and

the transport of the heat from the lead 3 to the radiation part 10a is substantially retarded. More specifically, the heat that is applied to an outer lead part 3b of the lead 3 and conducted along the lead 3 to an inner lead part 3a at the time of soldering the lead has to travel through the resin package body 5 until it reaches the heat radiation part 3a or the heat conduction part 3b. Compare the structure of FIG.2(A) with the conventional structure of FIG.1(E) where the separation between the lead 3 and the heat dissipation block 9 is minimum. On the other hand, the heat that has been generated in the semiconductor chip 1 due to the operation of the semiconductor device is immediately transferred to the heat radiation part 10a through the heat conduction part 10b, and the accumulation of heat in the resin package does not occur.

In the experiment conducted for the package wherein the surface area of the top surface A is set at bout 90 % of the entire top surface S of the package body 5, it was found that the thermal resistance is reduced by about 50 % as compared with the conventional device shown in FIG.1(A). In the experiment, a package of the QFP having the size of 28 X 28 X 3.35 mm and 208 pins extending therefrom was used and the thermal resistance of about 24 °C/W was observed. In the experiment, the distance $\ell$ was set to 1.0 mm.

Any material having an excellent heat conductivity may be employed for the heat sink 10. For example, metals such as aluminum, copper, copper-tungsten alloy, copper-molybdenum alloy, and aluminum-silicon alloy may be employed. Alternatively, ceramics such as AIN may be used. Further, some resins such as an epoxy resin filled with silica may be used.

The package of FIG.2(A) may be manufactured by providing the heat sink 10 in rigid connection with the semiconductor chip 1 held on the lead frame stage 2 by a solder or adhesive, placing the entire structure including the chip 1, lead frame 3 and the heat sink 10 in a cavity of a mold, and pouring a molten resin into the cavity to hold the heat sink 10 firmly in the resin package body 5. Alternatively, the package body 5 may be formed in a mold such that the top surface of the lead frame stage 2 is exposed, and attaching the heat sink 10 in contact with the exposed top surface of the lead frame stage 2 by a solder or adhesive after the package is formed.

Hereinafter, the process of fabrication of the semiconductor device of FIG.2(A) will be described with reference to a second embodiment of the present invention.

FIG.3 shows the structural feature of the second embodiment of the semiconductor device. In the present embodiment, the resin package body 5 is formed with a depression 11 on a top surface thereof such that the top surface of the lead frame stage 2 embedded in the package body 5 is exposed at the bottom part of the depression 11. The depression 11 generally has a shape corresponding to the heat sink 10 and the heat sink 10 is fitted into the depression 11 to establish a contact with the exposed top surface of the lead frame stage 2. There, the heat sink 10 is fixed on the lead frame stage 2 by an adhesive or solder.

In the present embodiment, it should be noted that there is formed a gap 11a between a side wall of the heat sink 10 and a side wall of the depression 11 such that the gap 11a surrounds the heat sink 10 laterally. Preferably, the size of the gap 11a may be set to 50 - 500 $\mu$m. The gap 11a communicates with an exterior of the package body 5. Thereby, any moisture or water that is released from the resin package body 11 escapes freely to the exterior of the package body 5 without being trapped at the interface between the heat sink 10 and the package body 5, and the formation of cracks in the package body 5 due to the water is effectively eliminated. It should be noted that the gap 11a includes two parts, one formed between the side wall of the heat radiation part 10a and the package body 5 and the other formed between the side wall of the heat conduction part 10b and the package body 5, wherein these two parts are communicated with each other and further with the exterior of the package body 5.

It should be noted that one can mount the device of FIG.3 on a printed circuit board, etc. not only by the localized heating process such as laser heating of the lead 3 but also by the cheap surface mounting technology (SMT) wherein the device is placed on a printed circuit board and passed through a heating fixture to cause reflowing of the solder on the printed circuit board. It should be noted that any moisture or water released upon the heating of the package body is allowed to escape freely through the gap 11a surrounding the heat sink 10.

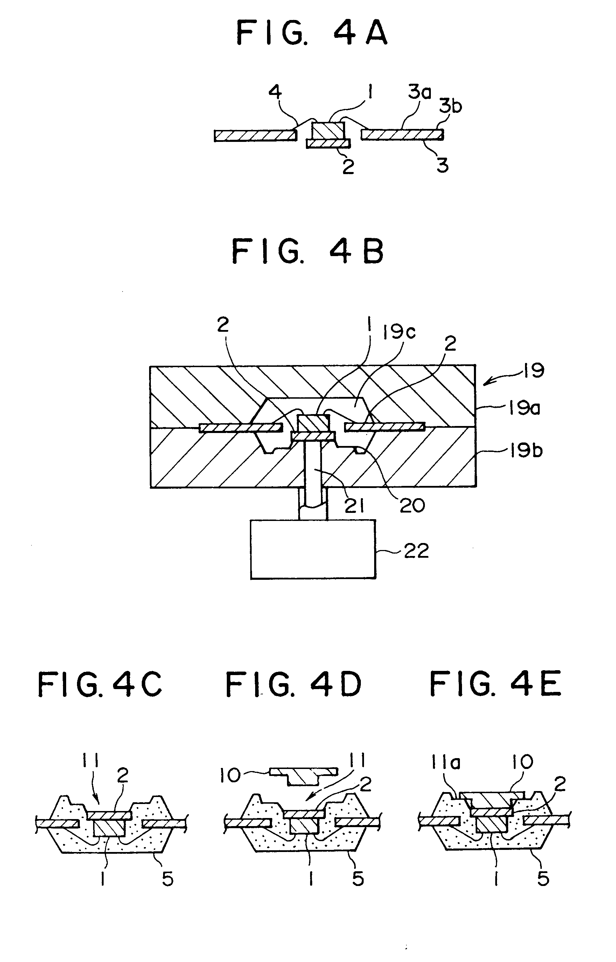

FIGS.4(A) - 4(E) show the process of manufacturing the device of FIG.3.

Referring to the drawings, the semiconductor chip 1 is bonded on a lead frame stage 2, and the interconnection between the semiconductor chip 1 and the inner lead part 3a of the lead 3 is achieved by the wire bonding of the interconnection wire 4. It should be noted that the lead 3 in the step of FIG.4(A) forms a frame.

In the next step of FIG.4(B), the semiconductor chip 1, the lead frame stage 2 and the lead frame 3 are placed on a lower part 19b of a mold 19, and an upper part 19a of the mold 19 is placed thereon. Thereby, there is formed a mold cavity 19c having a shape corresponding to the shape of the resin package body 5. Further, the semiconductor chip 1 is held firmly against the lower mold 19b by applying a suction through a vent 21 that leads to a pump 22.

In the state shown in FIG.4(B), a molten resin is poured into the cavity 19c and the mold 19 is removed after the resin is cured. Thereby, a half-completed device shown in FIG.4(C) is obtained. It should be noted that, in the device of FIG.4(C), the top surface of the lead frame stage 2 is exposed. Further, the depression 11 having a shape corresponding to the shape of the heat sink 10 is formed at the top surface of the package body 5. By applying the suction to the semiconductor chip 1 via the vent 21, the chip 1 and the stage 2 are held firmly on the mold 9b, and the problem of displacement of the chip during the pouring of the molten resin into the mold cavity 9c is positively eliminated.

Next, the heat sink 10 is attached to the exposed top surface of the lead frame stage 2 as shown in FIG.4(D), and the heat sink 10 is fixed thereon by an adhesive or solder. Thereby, it will be seen that the gap 11a is formed to surround the heat sink 10 laterally to provide the path of escape of water released by the resin forming the package body 5.

In the process described above, the displacement of the chip 1 in the mold cavity 19c is positively eliminated by applying the suction to the chip 1. Thereby, the delicate control hitherto necessary at the time of pouring the molten resin into the mold cavity for eliminating the displacement of the chip, can be eliminated and the yield as well as the throughput of the manufacturing process are improved.

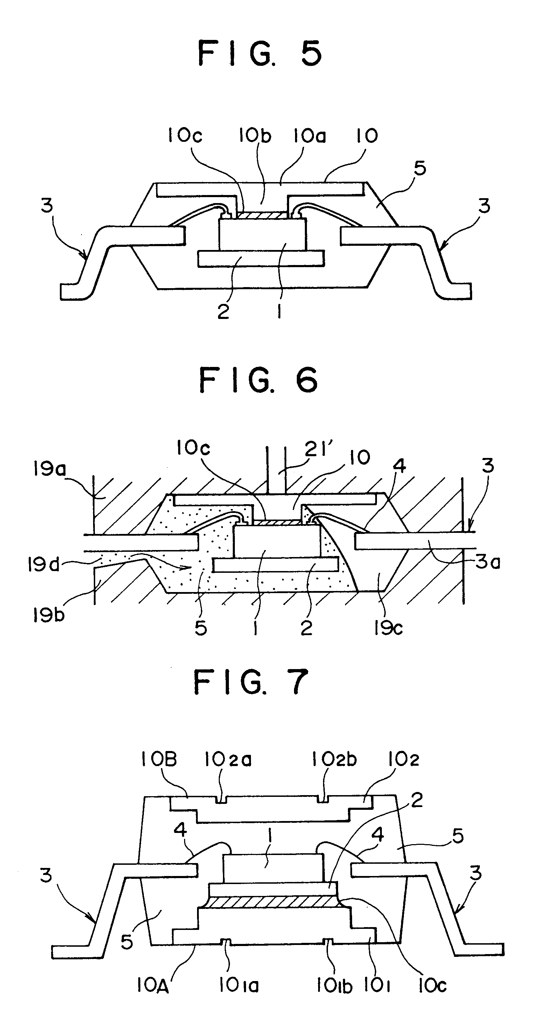

FIG.5 shows a third embodiment of the present invention.

Referring to FIG.5, the heat sink is provided directly on the semiconductor chip 1 at a side opposite to the side on which the lead frame stage 2 is provided. There, the heat sink 10 is rigidly connected to the chip 1 by an adhesive layer 10c that may be a silicone adhesive. Alternatively, the layer 10c may be a layer of solder. In this construction, too, one can obtain the effect of retarding the heat transfer from the lead 3 to the heat sink 10 while maintaining the efficient heat transfer from the chip 1 to the heat sink 10.

FIG.6 shows the manufacturing process of the semiconductor device of FIG.5.

In the present embodiment, too, the semiconductor chip 1 and the lead frame stage 2 are held in the mold cavity 19c formed in the mold 19, and the pouring of the molten resin into the cavity 19c is achieved via a gate 19d formed in the lower mold 19b.

In the present embodiment, it should be noted that the heat sink 10 is mounted directly on the chip 1 before the chip 1 is incorporated into the mold cavity 19c. More specifically, the chip 1 is mounted on the lead frame stage 2, and the chip 1 is connected to the inner leads 3a of the lead frame 3 by the bonding wire 4. After the lead frame 3 is thus connected to the chip 1, the heat sink 10 is attached to the upper major surface of the chip 1 by the adhesive layer 10c.

Next, the chip 1 and the lead frame 3 are incorporated into the mold cavity 19c together with the heat sink 10, and the heat sink 10 is held against the upper mold 19a by applying a suction thereto. For this purpose, the upper mold 19a of FIG.6 is provided with a vent 21' in connection with a pump not illustrated. By firmly holding the heat sink 10 and thus the semiconductor chip 1 attached thereto against the upper mold 19a, one can positively eliminate the drifting of the chip in the mold cavity 19c even when the molten resin is poured into the cavity 19c via the gate 19d. After the resin is thus poured into the cavity 19c and cured therein, the upper and lower molds 19a and 19b are removed and the device shown in FIG.5 is obtained.

FIG.7 shows a fourth embodiment of the present invention.

Referring to FIG.7, the semiconductor device includes a first heat sink $10_1$ corresponding to the heat sink 10 that is provided under the lead frame stage 2. The heat sink has an exposed bottom surface $10_A$ on which positioning grooves $10_{1a}$ and $10_{2a}$ are formed. Further, a second heat sink $10_2$ having a shape similar to the heat sink $10_1$ is provided at a top part of the package body 5. The heat sink $10_2$ has an exposed top surface $10_B$ on which positioning grooves $10_{2a}$ and $10_{2b}$ are formed. According to the present embodiment, one can reduce the thermal resistance further as compared with the device of previous embodiments, while still maintaining a sufficient thermal resistance between the lead and the heat sink.

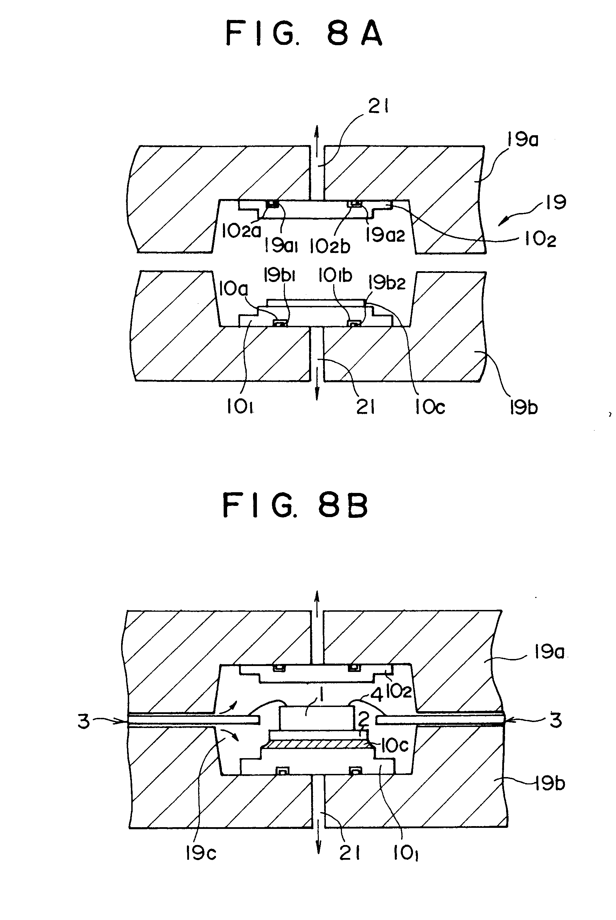

FIGS.8(A) and 8(B) show the process for manufacturing the semiconductor device of FIG.7.

Referring to the drawings, the heat sink $10_2$ is attached to the upper mold 19a by applying a suction through the vent 21'. There, the heat sink $10_2$ is provided such that the positioning grooves $10_{2a}$ and $10_{2b}$ engage with corresponding pins $19_{a1}$ and $19_{a2}$. Similarly, the heat sink $10_1$ is attached to the lower mold 19b such that the positioning grooves $10_{1a}$ and $10_{1b}$ engage with corresponding pins $19_{b1}$ and $19_{b2}$. Further, the heat sink $10_1$ is fixed firmly against the mold 19b by applying a suction via a vent 21. On the top surface of the heat sink $10_1$, the adhesive layer 10c is provided in the uncured state.

Next, the lead frame stage 2 carrying the semiconductor chip 1 therein is mounted on the lower mold 19b together with the lead frame 3 that is connected to the chip 1 by the bonding wire 4 as shown in FIG.8(B). There, the cavity 19c is formed between the upper mold 19a and the lower mold 19b, and the molten resin is poured into the cavity 19c. After the resin is cured, the molds 19a and 19b are removed and the device shown in FIG.7 is obtained. In this process, too, the displacement of the semiconductor chip 1 in the cavity 19c upon the pouring of the resin is effectively eliminated.

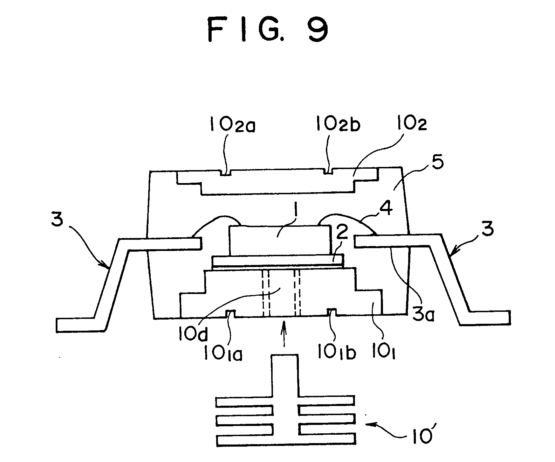

FIG.9 shows a fifth embodiment of the present invention.

Referring to FIG.9, the device of the present embodiment is substantially identical with the device of FIG.7 except that there is provided a threaded hole 10d that extends through the heat sink $10_1$ from the bottom surface to the top surface. Further, an external heat sink fin 10' is threaded into the hole 10d. According to the present embodiment, the thermal resistance of the package is further reduced, while still maintaining the desirable high thermal resistance between the lead and the heat sink.

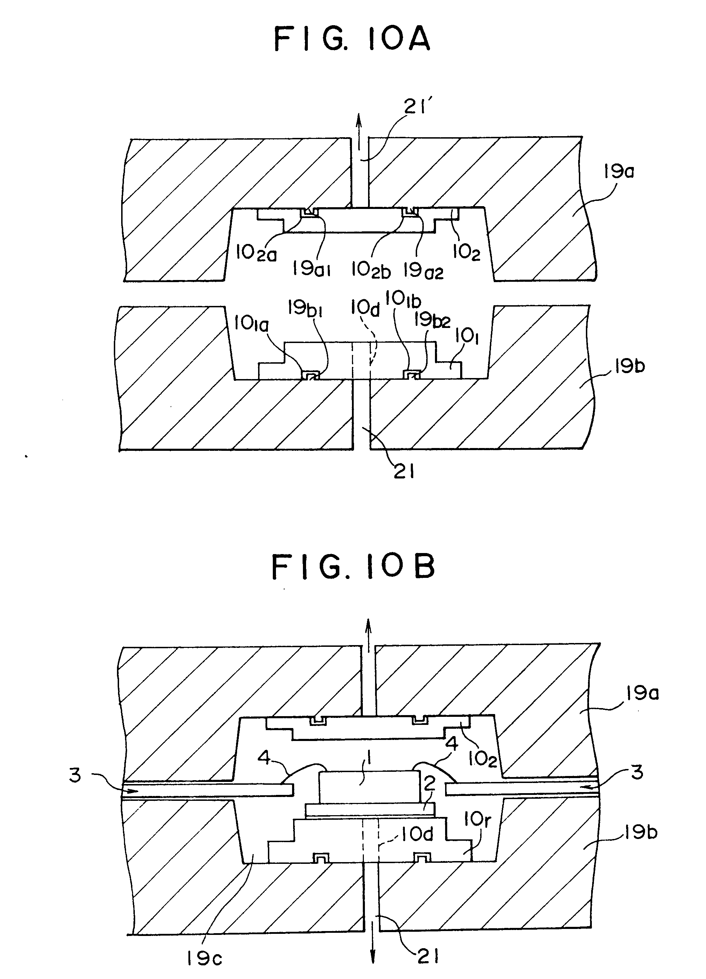

FIGS.10(A) and 10(B) are diagrams showing the manufacturing process of the semiconductor device of FIG.9.

Referring to FIG.10(A), the heat sink $10_2$ is attached to the upper mold 19a by engaging the positioning grooves $10_{2a}$ and $10_{2b}$ with corresponding positioning pins $19_{a1}$ and $19_{a2}$. Further, the heat sink $10_2$ is firmly held on the mold 19a by applying a suction via the vent 21'. Simultaneously, the heat sink $10_1$ is placed on the lower mold 19b by engaging the positioning grooves $10_{1a}$ and $10_{1b}$ with corresponding positioning pins $19b_1$ and $19b_2$. Thereby, the hole 10d in the lower mold $10_1$ is aligned with the vent 21 formed in the lower mold 19b.

Next, the semiconductor chip 1 mounted on the lead frame stage 2 and connected to the lead frame 3 via the bonding wire 4, is placed on the lower mold 19b as shown in FIG.10(B). There, the lower surface of the lead frame stage 2 may be bonded to the upper surface of the heat sink $10_1$ by an adhesive layer such as silicone. Further, the upper mold 19a carrying thereon the heat sink $10_2$ is placed on the lower mold 19b to form the mold cavity 19c therebetween. Furthermore, the molten resin forming the package body 5 is poured into the mold cavity 19c as usual. After curing the resin, the mold 19 is dismantled and the device shown in FIG.9 is obtained.

Next, a sixth embodiment of the present invention will be described with reference to FIG.11.

Referring to FIG.11, the device has a structure similar to the device of FIG.7 except that there is provided a support block 31 of a heat conducting material similar to the heat sink such that the block 31 extends between the top surface of the chip 1 and the bottom surface of the heat sink $10_2$. There, the block 31 is formed as a part of the heat sink $10_2$ and bonded to the top surface of the chip 1 by an adhesive layer 10c' that is similar to the adhesive layer 10c.

According to the present embodiment, the displacement of the chip 1 in the mold at the time of pouring of the molten resin is positively prevented, as the vertical movement of the chip 1 in the cavity is restricted by the support block 31. Further, the lateral movement is restricted by the engagement of the positioning grooves with corresponding pins on the mold similar to the case of FIG.8(A) and 8(B), except that the suction for holding the heat sinks $10_1$ and $10_2$ is not necessary. Thereby, the manufacturing process is substantially simplified. In this embodiment, too, the dissipation of the heat applied to the lead 3 upon mounting the device on a substrate such as a printed circuit board, is effectively suppressed by increasing the distance between the inner lead part 3a and the radiating part of the heat sink $10_1$ and $10_2$. Thus, the device of the present embodiment is easily mounted on the substrate by soldering, while still maintaining efficient heat dissipation by the two heat sinks $10_1$ and $10_2$.

Further, the present invention is not limited to the embodiments described heretofore, but various variations and modifications may be made without departing from the scope of the invention.

## Claims

1. A packaged semiconductor device comprising: a chip assembly (1, 2) including a semiconductor chip (1) and a lead frame (2) that supports the semiconductor chip thereon, said chip assembly having a first major surface and a second, opposing major surface; characterized in that said packaged semiconductor device further comprises:

a heat dissipating block (10) having a first major surface (B) and a second, opposing major surface (A), said first major surface of the heat dissipating block having a first surface area and establishing a contact with said first major surface of the chip assembly, said second major surface of the heat dissipating block having a second surface area substantially larger than said first surface area;

a resin package body (5) having first and second, opposing major surfaces and accommodating therein said chip assembly between said first major surface and said second major surface of the package body;

said heat dissipating block being provided such that said second major surface of the heat dissipating block being exposed at the second major surface of the package body;

an interconnection lead (3) held by the package body and extending outward therefrom for external electrical connection; and

a bonding wire (4) extending inside the package body for connecting the interconnection lead to the semiconductor chip.

2. A packaged semiconductor device as claimed in claim 1 characterized in that said second major surface (S) of the package body having a third surface area wherein said second surface area of said second surface (A) of the heat dissipating block is equal to or larger than 90 percent of the third surface area.

3. A packaged semiconductor device as claimed in claim 1 characterized in that said heat dissipating block (10) comprises a heat radiation part (10a) and a heat conduction part (10b), said heat radiation part having a first major surface and a second, opposing major surface that is coincident with said second major surface of the heat dissipating block, said heat conduction part having a first major surface coincident with said first major surface of the heat dissipating block and extending from the first major surface of the heat radiation part.

4. A packaged semiconductor device as claimed in claim 3 characterized in that said first major surface of the heat radiation part (10a) is separated from said lead (3) by a distance ($\ell$) set larger than 1.0 mm.

5. A packaged semiconductor device as claimed in claim 1 characterized in that said packaged semiconductor device further comprises a second heat dissipating block ($10_2$) having a first major surface and a second, opposing major surface, said first major surface and said second major surface of said second heat dissipating block respectively having third and fourth surface areas wherein said fourth surface area is formed substantially larger than said third surface area, said second heat dissipating block being provided such that said second major surface of said second heat dissipating block is exposed at the first major surface of the package body.

6. A packaged semiconductor device as claimed in claim 5 characterized in that said second heat dissipating block ($10_2$) is provided such that said first major surface of said second heat dissipating block faces the second major surface of the chip assembly with a separation therefrom.

7. A packaged semiconductor device as claimed in claim 5 characterized in that said second heat dissipating block ($10_2$) is provided such that said first major surface of said second heat dissipating block establishes a contacting engagement with said first major surface of said chip assembly (1).

8. A packaged semiconductor device as claimed in claim 3 characterized in that said heat radiation part (10a) and said heat conduction part (10b) have respective first and second side walls, said first side wall of the heat radiation part extending between said first and second major surfaces of said heat radiation part and surrounding said heat radiation part, said second side wall of the heat conduction part extending between said first major surface of the heat radiation part and said first major surface of the heat conduction part and surrounding the heat conduction part, each of said first and second side walls being separated from said package body to form a space (11a) between the package body (5) and the side walls.

9. A packaged semiconductor device as claimed in claim 8 characterized in that said space (11a) is communicated with an exterior of the package body (5).

10. A packaged semiconductor device as claimed in claim 9 characterized in that said gap has a size of 50 μm - 500 μm when measured in a direction outward from said side wall of the heat radiation part (10a).

11. A packaged semiconductor device as claimed in claim 1 characterized in that said heat dissipating block ($10_1$) has a threaded hole (10d) opening at the exposed second major surface of the heat dissipating block for mounting an external heat radiation unit (10').

12. A packaged semiconductor device as claimed in claim 1 characterized in that said chip assembly comprises the semiconductor chip (1) and a lead frame stage (2) for supporting the semiconductor chip, said lead frame stage having a first major surface for supporting the semiconductor chip thereon and a second, opposing major surface that is coincident with the first major surface of the chip assembly.

13. A packaged semiconductor device as claimed in claim 1 characterized in that said chip assembly comprises the semiconductor chip (1) and a lead frame stage (2) for supporting the semiconductor chip, said semiconductor chip having a major surface coincident with said first major surface of the chip assembly.

14. A method for manufacturing a semiconductor device, said semiconductor device having a resin package body, characterized by the steps of:
established an interconnection (4) between a semiconductor chip (1) mounted on a lead frame (2, 3) and an inner lead (3a) formed on said lead frame (3) to form a chip assembly, said chip assembly comprising said semiconductor chip and the lead frame;
incorporating the chip assembly into a cavity (19c) of a mold (19), said cavity having a shape corresponding to the shape of a package body (5) to be formed, said chip assembly being so provided in said cavity such that a part of the chip assembly establishes an intimate contact with an inner surface of the mold;
applying a suction via a vent (21) formed in the mold such that the chip assembly is held firmly against the inner surface of the cavity;

pouring a molten resin into said cavity while holding firmly the chip assembly against the inner surface of the cavity;
curing the molten resin to form the resin package body such that the chip assembly is embedded in the resin package body; and
mounting a heat dissipating structure (10) on said resin package in correspondence to said part of the chip assembly that has been contacted with said mold in the step of pouring the molten resin.

15. A method as claimed in claim 14 characterized in that said mold (19) has a vent (21) for evacuating the cavity (19c), and said step of incorporating the chip assembly into the cavity is achieved such that said chip assembly establishes an intimate contact with the inner wall of the cavity in correspondence to a part where the vent is formed.

16. A method for manufacturing a semiconductor device having a resin package body, characterized by the steps of:
establishing an interconnection (4) between a semiconductor chip (1) mounted on a lead frame (2, 3) and an inner lead (3a) formed on said lead frame (3) to form a chip assembly, said chip assembly comprising said semiconductor chip and the lead frame;
mounting a heat dissipating block (10, $10_1$) for dissipating heat generated by the semiconductor device, on said chip assembly such that the heat dissipating block establishes a rigid connection with said chip assembly;
incorporating the chip assembly into a cavity (19c) of a mold (19) together with said heat dissipating block, said cavity having a shape corresponding to the shape of a package body (5) to be formed, said chip assembly and heat dissipating block being so provided in said cavity that said heat dissipating block establishes an intimate contact with an inner surface of said cavity;
applying a suction via an evacuation vent (21) formed in the mold such that the heat dissipating block is held firmly against the inner surface of the cavity; and
pouring a molten resin into said cavity while holding firmly the heat dissipating block against the mold by applying the suction.

17. A semiconductor device as claimed in claim 16 in which said mold (19) comprises a first mold part (19b) having a first depression and a second mold part (19a) having a second depression, said first depression and said second depression forming said cavity (19C) when said first mold part and said second mold part are assembled with each other, said step of incorporating the chip assembly into the cavity of the mold comprises the steps of mounting the chip assembly on said first cavity of the first mold part in correspondence to a part where said evacuation vent (21) is formed for evacuating the cavity, and placing the second mold part on said first mold part such that said cavity is formed by the first and second depressions.

18. A semiconductor device as claimed in claim 17 characterized in that said method further comprises a step of mounting a second heat dissipating block ($10_2$) on said second depression in correspondence to a part in which a second evacuation vent (21') is formed, said step of placing the second mold part being achieved while applying a suction through said second evacuation vent such that the second heat dissipating block is held firmly against the second depression of the second mold.

19. A method for manufacturing a semiconductor device having a resin package body, characterized by the steps of:

establishing an interconnection (4) between a semiconductor chip (1) mounted on a lead frame (2, 3) and an inner lead (3a) formed on said lead frame (3) to form a chip assembly, said chip assembly comprising said semiconductor chip and said lead frame;

mounting a first heat dissipating block ($10_1$) for dissipating heat generated by the semiconductor device, on a lower mold part (19b) having a first depression, said first heat dissipating block being provided with a through hole (10d) and mounted on said first depression such that the through hole is aligned with an evacuation vent (21) formed in said first depression part;

mounting the chip assembly on said first heat dissipating block held in the first depression such that the chip assembly closes the through hole in the first heat dissipating block;

applying a suction via said evacuation vent (21) such that the chip assembly and the heat dissipating block are held firmly against an inner surface of the first depression;

placing an upper mold part (19a) formed with a second depression such that the second depression faces the first depression to form a cavity corresponding to the shape of the resin package body by said first and second depressions; and

pouring a molten resin into said cavity while applying the suction via the vent.

20. A method for manufacturing a semiconductor device having a resin package body, characterized by the steps of:

establishing an interconnection (4) between a semiconductor chip mounted on a lead frame (2, 3) and an inner lead (3a) formed on said lead frame (3) to form a chip assembly, said chip assembly comprising said semiconductor chip and said lead frame and having upper and lower major surfaces;

mounting said chip assembly on a lower heat dissipating block ($10_1$) such that the lower major surface of the chip assembly is connected to the lower heat dissipating block rigidly, said lower heat dissipating block having a lower major surface;

mounting an upper heat dissipating block ($10_2$) on said upper major surface of said chip assembly such that the upper heat dissipating block is connected to said chip assembly rigidly, said upper heat dissipating block having an upper major surface;

placing the chip assembly together with the upper and lower heat dissipating blocks connected thereto, into a mold (19) that is formed with a cavity having upper and lower inner walls, such that the upper major surface of the upper heat dissipating block engages with the upper inner wall of the cavity and such that the lower major surface of the lower heat dissipating block engages with the lower inner wall of the cavity; and

pouring a molten resin into said cavity to form the resin package body.

# FIG.IA
## PRIOR ART

# FIG.IB
## PRIOR ART

▲20%

# FIG.IC
## PRIOR ART

▲50%

# FIG.ID
## PRIOR ART

▲30%

# FIG.IE
## PRIOR ART

▲60%

# F I G. 2 A

# F I G. 2 B

# F I G. 2 C

# F I G. 3

# FIG. 4 A

# FIG. 4 B

# FIG. 4C     FIG. 4D     FIG. 4E

# F I G. 5

# F I G. 6

# F I G. 7

# FIG. 8A

# FIG. 8B

# F I G. 9

# F I G. IOA

# F I G. IO B

**European Patent Office**

## EUROPEAN SEARCH REPORT

Application Number

EP 91 31 0135
PAGE 1

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-232837 (MATSUSHITA ELECTRIC INDUSTRIAL) <br> * column 14, lines 32 - 41; figure 11 * | 1, 3, 12 | H01L23/31 <br> H01L23/433 |
| Y | * ditto * | 5, 7-9, 11, 13 | H01L21/56 |
| | --- | | |
| X | DE-A-2443988 (PHILIPS PATENTVERWALTUNG) <br> * page 3; figures 1, 2 * | 1, 3, 12 | |
| | --- | | |
| X | PATENT ABSTRACTS OF JAPAN <br> vol. 3, no. 132 (E-149) 06 November 1979, <br> & JP-A-54 111281 (MITSUBISHI DENKI) 31 August 1979, <br> * the whole document * | 16, 17 | |
| Y | | 18-20 | |
| | --- | | |
| Y | PATENT ABSTRACTS OF JAPAN <br> vol. 10, no. 370 (E-463)(2427) 10 December 1986, <br> & JP-A-61 166051 (MATSUSHITA ELECTRONICS) 26 July 1986, <br> * the whole document * | 5, 7, 13, 18, 20 | |
| | --- | | **TECHNICAL FIELDS SEARCHED (Int. Cl.5)** |
| Y | PATENT ABSTRACTS OF JAPAN <br> vol. 9, no. 197 (E-335)(1920) 14 August 1985, <br> & JP-A-60 063953 (HITACHI SEISAKUSHO) 12 April 1985, <br> * the whole document * | 8, 9 | H01L <br> 829C |
| | --- | | |
| Y | PATENT ABSTRACTS OF JAPAN <br> vol. 6, no. 012 (E-091) 23 January 1982, <br> & JP-A-56 133857 (FUJITSU) 20 October 1981, <br> * the whole document * | 11, 19 | |
| | --- | | |
| Y | PATENT ABSTRACTS OF JAPAN <br> vol. 10, no. 251 (E-432)(2307) 28 August 1986, <br> & JP-A-61 080843 (ROHM CO) 24 April 1986, <br> * the whole document * | 14, 15 | |
| | --- | | |
| | -/-- | | |

The present search report has been drawn up for all claims

| Place of search | Date of completion of the search | Examiner |
|---|---|---|
| BERLIN | 20 JANUARY 1992 | LE MINH I. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

European Patent
Office

## EUROPEAN SEARCH REPORT

Application Number

EP    91 31 0135
PAGE2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | PATENT ABSTRACTS OF JAPAN<br>vol. 5, no. 3 (E-40)(675) 10 January 1981,<br>& JP-A-55 134940 (CITIZEN TOKEI) 21 October 1980,<br>* the whole document *<br>--- | 14, 15 | |
| A | PATENT ABSTRACTS OF JAPAN<br>vol. 9, no. 298 (E-361)(2021) 26 November 1985,<br>& JP-A-60 137042 (MATSUSHITA DENSHI KOGYO) 20 July 1985,<br>* the whole document *<br>----- | 6 | |

TECHNICAL FIELDS
SEARCHED (Int. Cl.5 )

The present search report has been drawn up for all claims

| Place of search | Date of completion of the search | Examiner |
|---|---|---|
| BERLIN | 20 JANUARY 1992 | LE MINH I. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
........................................................
& : member of the same patent family, corresponding
   document

EPO FORM 1503 03.82 (P0401)